# EUROPEAN PATENT APPLICATION

(11) **EP 1 310 380 A1**
(43) Date of publication of application: **14.05.2003**
(21) Application number: 01309422.2
(22) Date of filing: 07.11.2001
(51) Int. Cl.: B42C 19/02, B81B 7/00

(54) **A micro-mechanical device and method for producing the same**

(71) Applicant: SensoNor asa, 3192 Horten (NO)
(72) Inventor: Habibi, Soheil c/o SensoNor asa, 3192 Horten (NO); Hedenstierna, Nils c/o SensoNor asa, 3192 Horten (NO)
(74) Representative: Haley, Stephen

(57) **Abstract**

A method for producing a multi-layer, micro-mechanical device. The device comprises an internal cavity having a micro-mechanical component therein. The method comprises the steps of forming the micro-mechanical component (8) from a layer of first material (7), providing a sealing layer (4,6) on at least one surface of the first material to define the cavity, providing a getter material (6) within the cavity, sealing the first material to the sealing layers by anodic bonding, supplying an inert gas to the cavity to regulate the pressure inside the cavity. A corresponding device produced by the method is also disclosed.

## Description

This invention relates to the field of multi-layer, micro-mechanical devices such as resonant accelerometers or micro-machined gyroscopes.

It is desirable to be able to regulate the physical characteristics of such devices in order to avoid potential problems. For example there is often a need for such devices to have a high quality (Q) factor. However, resonators with very high Q-factors may suffer from external vibration and shock, which can make unwanted modes resonate. Regulation may be achieved by controlling the pressure inside the packaging which defines the cavity of the device. In order to reduce this pressure, the device is individually packaged in vacuum or at low pressure and sealed. However, vacuum packaging of individual sensors is a costly process and is not, therefore, suited for high volume, low cost production.

Further influences on the pressure inside the cavity are seen due to variations that occur because of the process. For example, if anodic bonding is used, which is a well known technique for sealing at wafer level, and has many benefits, there is a certain amount of out-gassing as a by-product of the bonding if performed in vacuum. This causes the pressure inside the cavity to be higher than the base pressure of the bonding chamber and for it to be unpredictable, reducing the quality of the overall process to an extent that devices made with an anodic bonding process require considerable control circuitry to compensate for manufacturing variations in their Q factor. This out-gassing also means that high Q-factors are difficult to achieve as cavity pressure is not as low as might be desirable.

According to the present invention there is provided a method for producing a multi-layer, micro-mechanical device, the device comprising an internal cavity having a micro-mechanical component therein, the method comprising the steps of:
forming the micro-mechanical component from a layer of first material;
providing a sealing layer on at least one surface of the first material to define the cavity;
providing a getter material within the cavity; and
sealing the first material to the sealing layer by anodic bonding whilst supplying an inert gas to regulate the pressure inside the cavity.

According to the present invention there is further provided a multi-layer micro-mechanical device comprising:
a first layer, with a micro-mechanical component formed therein;
at least one sealing layer, wherein the first layer is anodically bonded thereto to define a cavity;
a getter provided within the cavity; and
an inert gas provided within the cavity such that the pressure within the cavity is regulated.

The anodic bonding process may be performed at a temperature in the range of 350°C to 450°C. The getter may be titanium and may be preformed on one of the sealing layers. The inert gas may be argon. There may be two sealing layers. The material of the micro-mechanical component may be silicon and the sealing layers may be made from glass or silicon or silicon sputtered by glass.

The device according to the present invention has a Q-factor which can be controlled to a high degree of accuracy, resulting in a device which requires little precise support circuitry yet which is accurate in terms of its measurement as well as resistant to vibration and shock and other external factors.

The process according to the invention is simple and cost-effective as well as ensuring that devices can be manufactured with a high degree of Q-factor control, reducing overall process wastage.

One example of the present invention will now be described with reference to the accompanying drawings, in which:
Figure 1 is a schematic diagram showing a process according to the present invention;
Figure 2 is a side view of a device according to the present invention.
Figure 3 are side views of a second device according to the present invention before and after a sealing stage is performed; and
Figure 4 is a side view of a further example device according to the present invention, again before and after sealing is performed.

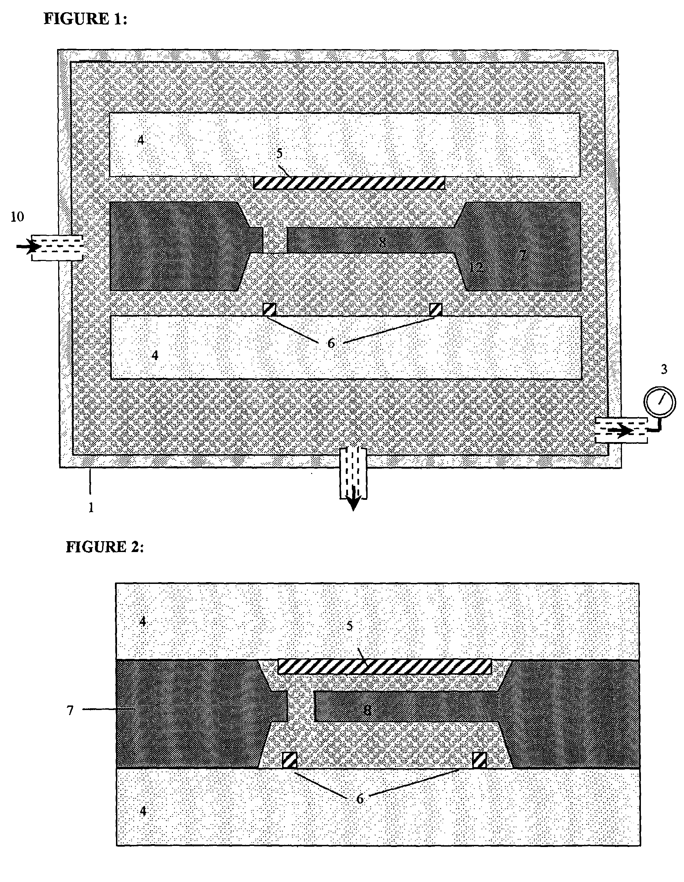

Referring to figure 1, a bonding chamber in which the method of the present invention is performed is kept at a controlled low pressure or vacumn by employment of a pump (not shown) attached to an outlet 2 and a pressure gauge 3. Inside the chamber 1 are positioned the component of a device to be manufactured. In this example, the device is a resonance type accelerometer or gyroscope.

The components inside the bonding chamber 1 include first and second encasing layers 4 which may be formed from glass, silicon or silicon sputtered with glass. Formed on the surface with one of the encasing layers 4 is a metal layer 5 which provides detecting circuitry for the end product of the process. Formed on the other encasing layer 4 are one or more getter components 6 which are formed from titanium or other appropriate getter material. Positioned between the two encasing layers 4 is a layer of silicon 7 which has been machined to have created thereon a device component 8.

A complete device 9 (figure 2) can be formed by sealing the encasing layers 4 to the silicon device layer 7 by known anodic bonding techniques. These techniques involve heating the components to a temperature in the region of 350 to 450°c and applying an appropriate electrical charge to perform the sealing. During this process oxygen is released from the encasing layers 4 in view of the high temperatures and charges being applied. In prior art methods this oxygen would be released into the cavity 11 and affect the controlled pressure during sealing. However, with the present invention the getter component 6 is provided which absorbs the oxygen that is produced in this manner. In order to provide accurate control of the pressure within the cavity 11 that is formed once sealing of the components 4, 7 has been completed, the method of the present invention also enables the provision of an inert gas, such as argon, into the bonding chamber 1 via an inlet 10. The end result of this (as shown in figure 2) is a cavity 11 in the end device 9 which has an inert gas sealed therein at a regulated pressure. Knowledge of this pressure and careful control of the machining of the silicon layer 7 to produce the device 8 results in a device which has a pre-determined Q-factor that is precise and can be repeated reliably by the manufacturing process.

As part of the silicon machining process it is usual, because of the isotropic nature of etching silicon crystal, for the device 8 to be formed such that sloped regions 12 are formed in the layer. These sloped regions are away from the main operating components of the device 8, and it is therefore particularly preferable to place the getter material in the general region of these sloped regions 12, and preferably completely underneath them so that they do not affect the electrostatic characteristics of the device 8 and hence the operation of that device. Doing this also eliminates the possibility of the device 8 moving and sticking to the getter material 6. For these reasons it is also preferable to place the getter material on the side of the cavity furthest away from the metal electrode 5. In this regard, it should be appreciated that it could be possible to alternatively form the getter material on the silicon substrate 7.

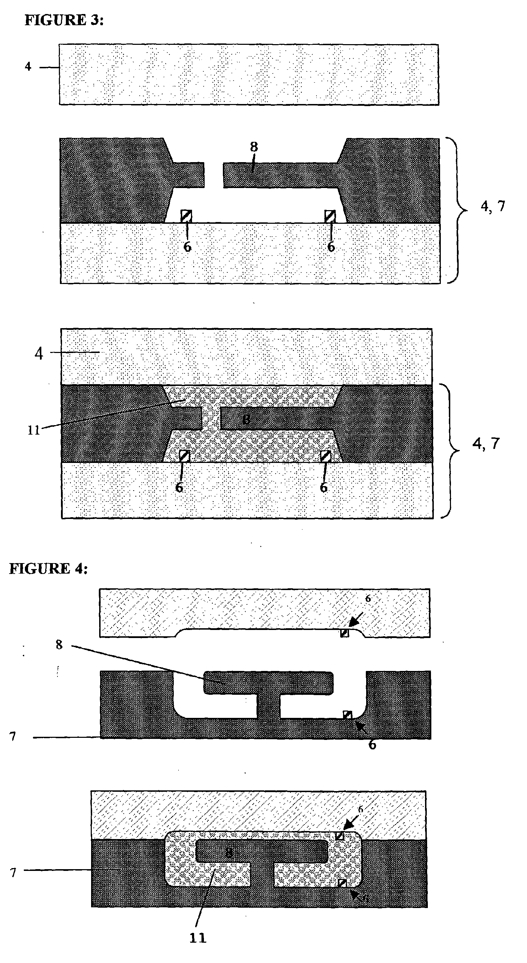

Figure 3 shows side views of an alternative example of the invention in which a bottom layer 4, formed from either glass or silicon, is attached to the silicon layer 7 by anyone of a known possible number of bonding techniques. Getters 6 are again provided. An upper layer 4, formed from glass, is then sealed onto the top of the device to form an end device 9 with a controlled pressure in its cavity 11, the cavity containing argon or similar inert gas.

Figure 4 shows side views of a further example device in which the whole base is formed from a single silicon layer or SOI layer 7 which is then anodically bonded to an upper sealing layer 4 of glass to provide a cavity 11 having similar pressure parameters to those of the earlier examples.

## Claims

1. A method for producing a multi-layer, micro-mechanical device, the device comprising an internal cavity having a micro-mechanical component therein, the method comprising the steps of:
forming the micro-mechanical component from a layer of first material;
providing a sealing layer on at least one surface of the first material to define the cavity;
providing a getter material within the cavity; and
sealing the first material to the sealing layer by anodic bonding whilst supplying an inert gas to regulate the pressure inside the cavity.

2. A method according to claim 1, wherein the anodic bonding process is performed at a temperature in the range of 350°C to 450°C.

3. A method according to either claim 1 or claim 2, wherein the getter is titanium.

4. A method according to any preceding claim, wherein the inert gas is argon.

5. A method according to any preceding claim, wherein the first material is silicon.

6. A method according to any preceding claim, wherein the sealing layer is made from one of glass or silicon sputtered by glass.

7. A method according to any preceding claim, wherein the getter is preformed on the sealing layer.

8. A method according to any preceding claims wherein two sealing layers are provided, each on a side of the first layer opposite to the other.

9. A multi-layer micro-mechanical device comprising:
a first layer, with a micro-mechanical component formed therein;
at least one sealing layer, wherein the first layer is anodically bonded thereto to define a cavity;
a getter provided within the cavity; and
an inert gas provided within the cavity such that the pressure within the cavity is regulated.

10. A device according to either claim 9, wherein the getter is titanium.

11. A device according to claim 9 or claim 10, wherein the inert gas is argon.

12. A device according to any of claims 9 to 11, wherein the material of the first layer is silicon.

13. A device according to any of claims 9 to 12, wherein the sealing layer is made from one of the group of glass or silicon sputtered by glass.

14. A device according to any of claims 9 to 13, wherein the getter is attached to the sealing layer.

15. A device according to any of claims 9 to 14 comprising two sealing layers, one on each side of the sealing layer.
